**Europäisches Patentamt**

**European Patent Office**

**Office européen des brevets**

(19)

(11)    **EP 1 264 401 B1**

(12)    **EUROPÄISCHE PATENTSCHRIFT**

(45) Veröffentlichungstag und Bekanntmachung des Hinweises auf die Patenterteilung:
**24.09.2003   Patentblatt 2003/39**

(51) Int Cl.$^7$: **H03K 6/04**

(21) Anmeldenummer: 01909427.5

(86) Internationale Anmeldenummer:
**PCT/DE01/00019**

(22) Anmeldetag: **05.01.2001**

(87) Internationale Veröffentlichungsnummer:
**WO 01/054275 (26.07.2001 Gazette 2001/30)**

(54) **ANORDNUNG UND VERFAHREN ZUM EINSTELLEN DER FLANKENZEITEN EINES ODER MEHRERER TREIBER SOWIE TREIBERSCHALTUNG**

ARRANGEMENT AND METHOD FOR ADJUSTING THE SLOPE TIMES OF ONE OR MORE DRIVERS AND A DRIVER CIRCUIT

DISPOSITIF ET PROCEDE POUR REGLER LES TEMPS DE MONTEE D'IMPULSION D'AU MOINS UN CIRCUIT D'ATTAQUE, ET CIRCUIT D'EXCITATION

(84) Benannte Vertragsstaaten:
**DE FR GB**

(30) Priorität: **20.01.2000   DE 10002376**

(43) Veröffentlichungstag der Anmeldung:
**11.12.2002   Patentblatt 2002/50**

(73) Patentinhaber: **Infineon Technologies AG**
**81669 München (DE)**

(72) Erfinder:
• **EICHFELD, Herbert**
  **80538 München (DE)**

• **KLEIN, Ralf**
  **80639 München (DE)**
• **PAULUS, Christian**
  **81247 München (DE)**
• **RÖMER, Dirk**
  **81479 München (DE)**

(74) Vertreter: **Viering, Jentschura & Partner**
**Steinsdorfstrasse 6**
**80538 München (DE)**

(56) Entgegenhaltungen:
| | |
|---|---|
| EP-A- 0 264 470 | DE-A- 4 018 754 |
| GB-A- 2 299 720 | US-A- 4 567 378 |
| US-A- 4 945 292 | |

**Beschreibung**

Anordnung und Verfahren zum Einstellen der Flankenzeiten eines oder mehrerer Treiber sowie Treiberschaltung

Die vorliegende Erfindung betrifft zunächst eine Anordnung und ein Verfahren zum Einstellen der Flankenzeiten eines oder mehrerer Treiber im wesentlichen unabhängig von äußeren Bedingungen. Weiterhin betrifft die Erfindung eine Treiberschaltung sowie vorteilhafte Verwendungen.

Treiber und Treiberschaltungen sind beispielsweise als Padtreiber integrierter Schaltungen wie Mikrocontroller, Mikroprozessoren, ASICs, Speicherbausteine oder dergleichen bekannt und bestimmen in großem Maße das elektromagnetische Verhalten (EMV) digitaler Baugruppen, wie zum Beispiel Steuergeräte in der Automobil- oder Automatisierungstechnik.

Ausschlaggebend für solche Treiber und Treiberschaltungen sind die relativ großen Stromtransienten (dI/dt) die notwendig sind, um die meist kapazitiven Lasten, die mit den Treibern verbunden sind, in relativ kurzer Zeit auf ein bestimmtes Spannungspotential zu laden, beziehungsweise zu entladen. Diese Zeiten, die Anstiegszeiten (rise time, trise) beziehungsweise Abfallzeiten (fall time, tfall) genannt werden, stehen für die steigende beziehungsweise fallende Flanke und sind in der Spezifikation des Treibers für eine bestimmte maximale Lastgröße angegeben. Üblicherweise wird die Treiberstärke derart ausgelegt, daß der Treiber bei den ungünstigsten, zulässigen Umgebungsbedingungen (worst case genannt) die garantierten Treiber- und Timingeigenschaften einhält.

Bei an sich bekannten CMOS-Schaltungen handelt es sich bei solchen worst-case-Bedingungen beispielsweise um hohe Umgebungstemperaturen, geringe Betriebsspannungen, ungünstige, das heißt zu "langsamen" Schaltzeiten führende Herstellungsparameter, eine maximale Lastgröße oder dergleichen. Da worst-case-Bedingungen in der Regel nur selten auftreten, sind die Ausgangsflanken derart dimensionierter konventioneller Treiber üblicherweise sehr viel steiler als gefordert, wodurch sich das Störspektrum verschlechtert. Ebenfalls sind auf Grund sich möglicherweise ändernder Umgebungsbedingungen auch die Flankenzeiten -Anstiegszeit/Abfallzeit- nicht konstant.

Ein bezüglich des elektromagnetischen Verhaltens idealer Treiber besitzt maximal erlaubt große Flankenzeiten, die unabhängig sind von äußeren Bedingungen, wie beispielsweise der Umgebungstemperatur, der Betriebsspannung, der individuellen Herstellungsparameter, der angeschlossenen Lastgröße oder dergleichen. Weiterhin hängen die maximal erlaubten Flankenzeiten von der jeweiligen Einsatzart der Treiber ab. So benötigen beispielsweise Speicherbusse eine viel kürzere Zugriffszeit als zum Beispiel Eingangssignale eines elektrischen Schalters (smart power switch genannt).

Untersuchungen haben gezeigt, daß durch eine Verringerung der Treiberstärke und eine damit verbundene Vergrößerung der Flankenzeiten eine signifikante Verbesserung des elektromagnetischen Verhaltens von Ausgangstreibern erzielt werden kann.

Es besteht daher das Bedürfnis, die Flankenzeiten von Treibern individuell einstellen zu können.

Aus der DE-A-44 415 23 C1 ist eine digitale Treiberschaltung für eine integrierte Schaltung bekannt, bei der die Treiberschaltung vom Bediener an eine bestimmte Anwendung selbst angepaßt werden kann. Dieser muß je nach Art der Anwendung, in diesem Fall je nach der Lastkapazität eines mit der Treiberschaltung zu betreibenden Bauelements, eine entsprechende Maßzahl in eine Eingabevorrichtung eingeben. Die Maßzahl ist eine von der Anwendung abhängige Größe. Bei dieser Schaltung handelt es sich strukturell um eine Steuerung. Bei der bekannten Lösung wird davon ausgegangen, daß durch Messung des Sättigungsstroms eines Meßtransistors Variationen in den Umgebungsbedingungen eindeutig bestimmt werden können.

In der EP-A-0 436 316 A1 ist weiterhin eine Schaltungsanordnung angegeben, die die Impedanz eines Treibers an ein angeschlossenes Netzwerk anpaßt. Dabei soll die Schaltungsanordnung geeignet sein, sich selbst an eine Last mit zunächst unbekannter Impedanz anpassen zu können. Dazu weist die Schaltungsanordnung einen Treiber mit einer vorbestimmten Impedanz auf. Ein Element zur wahlweisen Auswahl einer Impedanz ist mit dem Treiber verbunden und ruft bei Betätigung wahlweise Veränderungen der vorbestimmten Impedanz an eine gewünschte, unterschiedliche Impedanz der angeschlossenen Last hervor. Ein weiteres Element ist mit diesem Element zur Auswahl der Impedanz verbunden. Dieses Element mißt die Impedanzdifferenz zwischen dem Ausgang (output) des Treibers und einer mit diesem verbundenen digitalen Schaltung. Auf Grund der Meßwerte wird aus dem Element zum Auswählen der Impedanz eine geeignete Impedanz ausgewählt und der vorbestimmten, das heißt voreingestellten, Impedanz des Treibers hinzugefügt.

Aufgabe der vorliegenden Erfindung ist die Bereitstellung einer verbesserten Anordnung, beziehungsweise eines Verfahrens zum Einstellen der Flankenzeiten eines oder mehrerer Treiber sowie einer verbesserten Treiberschaltung, mit der/dem insbesondere die Flankenzeiten eines oder mehrerer Treiber auf einfache Weise und im wesentlichen unabhängig von äußeren Bedingungen eingestellt werden können.

Diese Aufgabe wird gemäß dem ersten Aspekt der Erfindung gelöst durch eine Anordnung zum Einstellen der Flankenzeiten eines oder mehrerer Treiber im wesentlichen unabhängig von äußeren Bedingungen, mit einer Vorrichtung zum Erfassen der Zeitdauer einer Flanke einer von dem/den Treiber (n) an eine Last ausgegebenen Ausgangsspannung, einer Vorrichtung zum Umwandeln der gemessenen Zeitdauer einer Flanke der Ausgangspannung in einen Ausgangsspannungswert, einer Vorrichtung zum Erzeugen eines Referenzspannungswerts, einer Einrichtung zum Vorgeben einer gewünschten, von äußeren Bedingungen im wesentlichen unabhängigen Flankenzeit für den/die Treiber, die mit der Vorrichtung zum Erzeugen eines Referenzspannungswerts verbunden ist, und mit einer Einrichtung zum Vergleichen des Ausgangsspannungswerts mit dem Referenzspannungswert, wobei die Vergleichseinrichtung mit dem/den Treiber(n) verbunden oder verbindbar ist.

Über die erfindungsgemäße Anordnung wird es möglich, die Flankenzeiten von Treibern unabhängig von äußeren Bedingungen einstellen zu können. Insbesondere wird es möglich, die Flankenzeiten der Treiber temperatur-, betriebsspannungs-, herstellungsprozeß- und lastunabhängig einstellen zu können. Die Aufzählung dieser äußeren Bedingungen ist rein exemplarisch, so daß die Flankenzeiten auch unabhängig von anderen, in dieser Aufzählung nicht explizit genannten äußeren Bedingungen eingestellt werden können.

Durch die erfindungsgemäße Anordnung wird erreicht, daß ein oder mehrere Treiber durch einen Regelzyklus, der sich vorzugsweise wiederholen kann, derart kalibriert wird/werden, daß vom Anwender eines solchen Treibers gewünschte und in weiten Grenzen wählbarer Flankenzeiten weitgehend unabhängig von den äußeren Bedingungen eingestellt und erreicht werden können.

Das Grundprinzip der erfindungsgemäßen Anordnung besteht darin, einen Referenzspannungswert, der der gewünschten und vom Anwender programmierbaren Flankenzeit entspricht, zu generieren. Dieser Referenzspannungswert wird mit einem tatsächlich gemessenen Ausgangsspannungswert verglichen. In Abhängigkeit von diesem Vergleichsergebnis wird der, beziehungsweise werden die Treiber angepaßt.

Wenn der/die Treiber aktiviert wird/werden, wird vom Treiber eine Ausgangsspannung ausgegeben. Diese Ausgangsspannung wird an eine Last weitergeleitet. Wenn es sich bei der mit dem/den Treiber(n) verbundenen Last um eine Lastkapazität handelt, wird diese Lastkapazität auf Grund der von dem/den Treiber(n) ausgegebenen Ausgangsspannung auf eine Betriebsspannung Vdd aufgeladen. Wenn der/die Treiber aktiviert wird/werden, wird die Ausgangsspannung am Treiberausgang steigen, bis die Betriebsspannung Vdd erreicht ist. Analoges gilt für den umgekehrten Fall.

Diese Zeitdauer einer Flanke der Ausgangsspannung wird von der Vorrichtung zum Erfassen der Zeitdauer einer Flanke, die im weiteren Verlauf der Beschreibung näher spezifiziert wird, erfaßt.

Da sich Zeitwerte im allgemeinen nur schlecht miteinander vergleichen lassen, werden die gemessenen Zeitwerte in der Vorrichtung zum Umwandeln der gemessenen Zeitdauer einer Flanke der Ausgangsspannung in einen Ausgangsspannungswert konvertiert. Dieser Ausgangsspannungswert kann zwischengespeichert werden.

Gleichzeitig wird in der Vorrichtung zum Erzeugen eines Referenzspannungswerts, die im weiteren Verlauf der Beschreibung noch näher erläutert wird, ein entsprechender Referenzspannungswert erzeugt. Die Erzeugung des Referenzspannungswerts erfolgt derart, daß über eine Einrichtung zum Vorgeben einer Flankenzeit vom Anwender der Anordnung eine gewünschte, frei wählbare und von äußeren Bedingungen im wesentlichen unabhängige Flankenzeit für den/die Treiber vorgegeben wird. Dieses Zeitsignal wird, aus den oben beschriebenen Gründen, wiederum in einen Spannungswert, den Referenzspannungswert, konvertiert. Der Referenzspannungswert kann wiederum zwischengespeichert werden.

Anschließend werden der Ausgangsspannungswert und der Referenzspannungswert in der Vergleichseinrichtung miteinander verglichen. Diese Vergleichseinrichtung ist ebenfalls mit dem/den Treiber(n) verbunden, beziehungsweise verbindbar, so daß über die von der Vergleichseinrichtung ausgegebenen Signale der/die Treiber, beziehungsweise dessen/deren Treiberstärke, angepaßt werden kann.

Bevorzugte Ausführungsformen der erfindungsgemäßen Anordnung ergeben sich aus den abhängigen Ansprüchen.

Die erfindungsgemäße Anordnung wird nachfolgend an Hand eines Beispiels erklärt, wobei es jedoch selbstverständlich ist, daß die Erfindung nicht auf die konkrete Beispielsform beschränkt ist. Diese dient lediglich dazu, die Zusammenhänge der erfindungsgemäßen Anordnung zu verdeutlichen.

Bei diesem Beispiel wird davon ausgegangen, daß in dem Moment, in dem ein Treibereingang-Input seinen Zustand ändert, der Treiber derart schaltet, daß über eine Treiber-Output-Leitung eine angeschlossene Last, beispielsweise eine Lastkapazität, geladen beziehungsweise entladen wird. Im folgenden wird davon ausgegangen, daß zum Zeitpunkt t=0 das Treibereingangssignal von "low" nach "high" wechselt, was bedeutet, daß die zuvor entladene Lastkapazität im weiteren Zeitverlauf auf die Betriebsspannung Vdd geladen werden soll. Für den umgekehrten Fall gilt analoges.

Vorzugsweise kann die Vorrichtung zum Erfassen der Zeitdauer einer Flanke der von dem/den Treiber(n) an eine Last ausgegebenen Ausgangsspannung als Fensterkomparator ausgebildet sein.

Dieser Fensterkomparator kann vorteilhaft zwei Spannungskomparatoren (CP1, CP2) aufweisen, die mit einem UND-Glied verbunden sind.

Über einen solchen Fensterkomparator kann der zeitliche Verlauf der Ausgangsspannung am Treiberausgang bis hin zur Betriebsspannung Vdd überwacht werden. Der Ausgang des Fensterkomparators kann beispielsweise während der Anstiegszeit oder der Abfallzeit des Spannungssignals auf "high" geschaltet werden.

Bei der Anstiegszeit, beziehungsweise der Abfallzeit, kann es sich beispielsweise um denjenigen Zeitraum handeln, den ein Signal benötigt, um von 10% auf 90% der Endspannung zu gelangen.

Dementsprechend können beispielsweise die beiden Spannungskomparatoren CP1, CP2 ausgestaltet sein. Einer der Spannungskomparatoren kann beispielsweise dann ein entsprechendes "high"-Signal liefern, wenn das Spannungssignal die 10%-Marke der Endspannung überschritten hat. Der andere Spannungskomparator kann beispielsweise solange ein "high"-Signal ausgeben, bis das Spannungssignal die 90%-Marke der Endspannung erreicht hat. Beide Signale der jeweiligen Spannungskomparatoren werden in dem UND-Glied zusammengeführt. Wenn beide Spannungskomparatoren ein "high"-Signal liefern, befindet sich das vom Treiber ausgegebene Spannungssignal in seiner Anstiegszeit, beziehungsweise in seiner Abfallzeit.

Formelmäßig kann der Ausgang des Fensterkomparators somit genau dann "high" sein, wenn gilt:

$$fu * Vdd < Vout < fo * Vdd,$$

mit zum Beispiel fu = 0,1, fo = 0,9, Vdd = Betriebsspannung und Vout = Ausgangsspannung.

In weiterer Ausgestaltung kann die Vorrichtung zum Umwandeln der gemessenen Zeitdauer einer Flanke der Ausgangsspannung in einen Ausgangsspannungswert eine Stromquelle, ein Schalterelement und eine Kapazität aufweisen, wobei das Schalterelement über Signale der Vorrichtung zum Erfassen der Zeitdauer einer Flanke der von dem/den Treiber(n) an eine Last ausgegebenen Ausgangsspannung betätigt wird oder betätigbar ist.

In dieser Vorrichtung wird der gemessene Zeitwert in einen Spannungswert konvertiert. Dazu kann das Schalterelement beispielsweise während des "high"-Zustandes der Vorrichtung zum Erfassen der Zeitdauer einer Flanke der Ausgangsspannung (vorteilhaft des Fensterkomparators) geschlossen werden, wodurch eine zuvor entladene Kapazität (beispielsweise eine Meßkapazität Cmeas) mittels der Stromquelle auf einen Ausgangsspannungswert (Vmeas) geladen wird.

Vorteilhaft kann die Vorrichtung zum Erzeugen eines Referenzspannungswerts eine Stromquelle, ein Schalterelement und eine Referenzkapazität aufweisen, wobei das Schalterelement über Signale der Einrichtung zum Vorgeben einer gewünschten Flankenzeit für den/die Treiber betätigt wird oder betätigbar ist. Über eine solche Struktur kann auf die wie vorstehend beschriebene Weise die Referenzkapazität (Cref) auf einen Referenzspannungswert (Vref) geladen werden.

Die Dauer, während der das Schalterelement geschlossen ist, wird durch den Anwender der Anordnung vorgegeben, indem dieser die Einrichtung zum Vorgeben einer gewünschten, von äußeren Bedingungen im wesentlichen unabhängigen Flankenzeit für den/die Treiber, die im weiteren Verlauf der Beschreibung noch näher erläutert wird, betätigt. Die Zeitdauer, während der das Schalterelement geschlossen ist, entspricht somit der gewünschten Anstiegszeit, beziehungsweise Abfallzeit.

In weiterer Ausgestaltung kann die Einrichtung zum Vergleichen des Ausgangsspannungswerts mit dem Referenzspannungswert als Komparator ausgebildet sein. Dieser Spannungskomparator (CP3) vergleicht den Ausgangsspannungswert (Vmeas) mit dem Referenzspannungswert (Vref). Wenn Vmeas < Vref gilt, wurde die Kapazität für die Ausgangsspannung kürzer geladen als die Referenzkapazität. Die tatsächliche Anstiegszeit, beziehungsweise Abfallzeit, war demnach kürzer als die gewünschte. Der Spannungskomparator (CP3) kann dies beispielsweise durch die Ausgabe eines "high"-Pegels anzeigen, wodurch die Treiberfähigkeit eines angeschlossenen Treibers reduziert wird. Für den Fall Vmeas > Vref gilt analoges.

Bei der nächsten steigenden, beziehungsweise fallenden, Flanke beginnt der Regelzyklus von neuem, so daß der Treiber sukzessive an die Last und die gewünschte Flankenzeit angepaßt wird.

Vorzugsweise kann eine Vorrichtung zum Auswählen der Treiberstärke vorgesehen sein, wobei diese Vorrichtung mit der Einrichtung zum Vergleichen des Ausgangsspannungswerts mit dem Referenzspannungswert verbunden ist und wobei die Vorrichtung zum Auswählen der Treiberstärke weiterhin mit dem/den Treiber(n) verbunden oder verbindbar ist. Die Vorrichtung kann über entsprechende Steuerleitungen, die beispielsweise "driver enable bus (DEB)" genannt werden, mit dem/den Treiber(n) verbunden sein.

Vorzugsweise kann die Einrichtung zum Vorgeben der gewünschten Flankenzeit für den/die Treiber zum Erzeugen eines Rechteckpulses, dessen Länge der gewünschten Flankenzeit entspricht, ausgebildet sein.

Wesentlich für die Güte der Treiberregelung, beziehungsweise Treibereinstellung, ist die exakte Generierung der gewünschten Flankenzeit. Sie darf nicht von äußeren Bedingungen, beispielsweise Variationen im Herstellungsprozeß, Schwankungen der Umgebungstemperatur, der Höhe der Versorgungsspannungen oder dergleichen abhängen. On-Chip-Schaltungen scheiden weitestgehend aus, da sie diesen Einflüssen unterworfen sind und eine Kompensation großen Aufwand erfordern würde.

Deshalb kann vorteilhaft vorgesehen sein, daß die Einrichtung zum Vorgeben der gewünschten Flankenzeit für den/die Treiber zur Verarbeitung eines Systemtakts ausgebildet ist. Ein solcher Systemtakt ist beispielsweise bei Mikrocontrollern, Mikroprozessoren und den meistes ASICs vorhanden. Der Systemtakt wird meistens aus einem externen Quarz, beziehungsweise Oszillator, generiert und kann als konstant bezüglich der genannten äußeren Bedingungen angenommen werden.

Ist die Taktfrequenz des Systemtakts gleich fmc (mc = master clock), so kann die Pulslänge $t=1/(2^*fmc)$ direkt abgegriffen werden. Unterschiedliche Pulsbreiten der Dauer $t=2^{\wedge} n/ (2*fmc)$ mit $n > 0$ können durch Frequenzteiler realisiert werden.

Werden Pulslängen mit $t<1/(2^*fmc)$ benötigt, können sogenannte Phase-Locked-Loop-Schaltungen verwendet werden. Ebenso ist es möglich, eine Schaltung zu verwenden, die die nachfolgend beschriebenen Merkmale aufweist.

Vorzugsweise kann die Einrichtung zum Vorgeben der gewünschten Flankenzeit für den/die Treiber ein oder mehrere Verzögerungsglieder aufweisen. Jedes Verzögerungsglied verzögert die Ausgabe der steigenden Flanke seines Eingangs, abhängig von einer Kontrollspannung (Vctrl). Eingangssignal ist beispielsweise ein relativ niederfrequenter Systemtakt, der bei Verwendung mehrerer Verzögerungsglieder eine Kette solcher Verzögerungsglieder durchläuft.

Weiterhin kann die Einrichtung zum Vorgeben der gewünschten Flankenzeit für den/die Treiber wenigstens einen Phasendetektor aufweisen. Ein solcher Phasendetektor überprüft, ob die fallende Flanke des Eingangssignals (master clock) zeitgleich mit der verzögert ausgegebenen steigenden Flanke am Ausgang der Verzögerungskette auftritt.

Ist dies nicht der Fall, wird abhängig davon, welcher Pegelwechsel zuerst stattfand, die Kontrollspannung derart geändert, daß im nächsten Zyklus die Phasendifferenz kleiner wird. Zur Erzeugung der Kontrollspannung kann beispielsweise eine Vorrichtung zum Erzeugen einer solchen Kontrollspannung vorgesehen sein.

Die fallende Flanke des Eingangssignals kann nahezu unverzögert durch das Verzögerungsglied, beziehungsweise die Verzögerungsglieder geleitet werden. Wird das Eingangssignal jeweils mit dem Ausgang eines jeden Verzögerungsgliedes über entsprechende UND-Glieder verknüpft, stehen mit dem Eingangssignal selbst n parallele Signale an, die "high"-Pegellängen von $tmin, 2^*tmin, 3^*tmin, ..., n^*tmin$ besitzen, mit $n$ = Anzahl der Verzögerungsglieder, und $tmin = 1/(2^*n^*fmc)$.

Vorteilhaft kann die Einrichtung zum Vorgeben der gewünschten Flankenzeit für den/die Treiber wenigstens ein Schalterelement, insbesondere einen Multiplexer, zum Umschalten zwischen verschiedenen Flankensignalen aufweisen. Über dieses Schalterelement kann der Anwender ein von ihm gewünschtes Signal, das dann der gewünschten Flankenzeit entspricht, auswählen. Vorzugsweise ist das Schalterelement als Multiplexer ausgebildet. Derartige Multiplexer sind an sich bereits bekannt. Sie weisen einen Dekoder auf, der aus n Eingängen einen gewünschten auswählen kann, und diesen anschließend auf einen Ausgang durchschaltet. In der CMOS-Technik kann man Multiplexer sowohl mit Gattern als auch mit Analogschaltern realisieren.

Durch eine derartige Ausgestaltung der Einrichtung zum Vorgeben der gewünschten Flankenzeit für den/die Treiber können zunächst auf einfache und dennoch sehr genaue Weise Schwankungen in den äußeren Bedingungen ausgeregelt werden. Weiterhin hat eine solche Einrichtung den Vorteil, daß zwischen der gewählten Ausgangspulsdauer (Flankenzeit) und der Systemtaktfrequenz ein fester und eindeutiger Zusammenhang besteht.

Gemäß einem zweiten Aspekt der vorliegenden Erfindung wird eine Treiberschaltung zum Treiben einer Last bereitgestellt, die einen oder mehrere Treiber aufweist, der/die mit der Last verbunden ist/sind. Diese Treiberschaltung ist erfindungsgemäß dadurch gekennzeichnet, daß der/die Treiber mit einer wie vorstehend beschriebenen erfindungsgemäßen Anordnung zum Einstellen der Flankenzeiten verbunden ist/sind.

Die erfindungsgemäße Treiberschaltung ermöglicht, daß sich der/die Treiber durch einen - vorteilhaft sich wiederholenden - Regelzyklus derart kalibriert/kalibrieren, daß die vom Anwender gewünschten und in weiten Grenzen wählbaren Flankenzeiten weitgehend unabhängig von äußeren Bedingungen eingestellt, beziehungsweise erreicht werden können. Zu den Vorteilen, Wirkungen, Effekten und der Funktionsweise der erfindungsgemäßen Treiberschaltung wird ebenfalls auf die vorstehenden Ausführungen zur erfindungsgemäßen Anordnung sowie die nachstehenden Ausführungen zum erfindungsgemäßen Verfahren vollinhaltlich Bezug genommen und hiermit verwiesen.

Bevorzugte Ausführungsformen der Treiberschaltung ergeben sich aus den abhängigen Ansprüchen.

Vorzugsweise kann/können der/die Treiber als skalierbare(r) Treiber ausgebildet sein.

Vorteilhaft kann jeder Treiber jeweils aus einem oder mehreren Teiltreibern bestehen. Die Verwendung mehrerer Teiltreiber ist an sich bekannt und beispielsweise in der von der Anmelderin ebenfalls eingereichten DE-195 45 904 beschrieben.

Wenn ein skalierbarer Treiber aus einer bestimmten Anzahl, vorzugsweise paralleler, Teiltreiber besteht, können diese mittels Steuerleitungen (driver-enable-bus, DEB) individuell freigegeben oder gesperrt werden. Wechselt der Treibereingang-Input seinen Zustand, schalten entsprechend alle freigegebenen Teiltreiber und laden, beziehungsweise entladen, über die Treiberleitung-Output eine angeschlossene Last.

Die Splittung des Treibers in mehrere Teiltreiber hat den weiteren Vorteil, daß bei kleiner Treiberleistung ein großer Ausgangswiderstand erhalten werden kann, und daß damit eine geringere Überkopplung von Störungen auf die Versorgungsleitungen bewirkt werden kann. Weiterhin ist es sinnvoll, die Transistorweiten jeder Treiberstufe jeweils doppelt so groß zu machen, wie die der nächst kleineren Stufe. Damit kann die Auswahl der Treiberstufen durch einen als binären Zähler ausgebildeten "driver-strength-selector" ausgeführt werden, wodurch der resultierende Treiberstärkenbereich in gleichen Stufen abgedeckt wird.

Die Zunahme, beziehungsweise Abnahme, der Treiberleistung nach einem Regelzyklus kann beispielsweise dabei der Treiberleistung der kleinsten Treiberstufe entsprechen.

Vorteilhaft kann jeweils ein oder mehrere Treiber mit einer Anordnung zum Einstellen der Flankenzeiten verbunden sein. Wie eingangs bereits beschrieben wurde, werden Treiber vorzugsweise im Rahmen integrierter Schaltungen eingesetzt. Derartige Schaltungen sind beispielsweise auf einem Chip integriert, auf dem üblicherweise nur sehr wenig Platz zur Verfügung steht. Zur Einsparung von Chipfläche sind vorzugsweise weniger Anordnungen zum Einstellen der Flankenzeiten als mit diesen verbundene Treiber vorgesehen.

Dabei können die einzelnen Treiber über geeignete Schalterelemente, beispielsweise einen wie bereits oben beschriebenen Multiplexer, mit jeweils einer Anordnung verbunden sein. Dadurch können die Stärken mehrerer, vorteilhafterweise skalierbarer, Ausgangstreiber nacheinander eingeregelt werden, wobei die jeweiligen, optimalen Treiberstärken zwischengespeichert werden können. Weiterhin kann durch eine solche Schaltungsanordnung vorteilhaft erreicht werden, daß die Regelung nur in bestimmten Phasen, beispielsweise den sogenannten set-Up-Phasen durchgeführt wird und danach die gefundenen Treiberstärken in geeignet gewählten Zeitabständen überprüft werden.

Vorteilhaft kann die mit dem/den Treiber(n) verbundene Last als kapazitive Last ausgebildet sein. Dies ist insbesondere im Bereich von CMOS-Schaltungen die häufigste Ausgestaltungsform solcher Lasten. Dennoch ist die Erfindung nicht auf kapazitive Lasten beschränkt, so daß auch ohmsche oder induktive Lasten sowie beliebige Kombinationen der einzelnen Lasttypen durchaus denkbar sind.

Gemäß einem dritten Aspekt der vorliegenden Erfindung wird ein Verfahren zum Einstellen der Flankenzeiten eines oder mehrerer Treiber im wesentlichen unabhängig von äußeren Bedingungen bereitgestellt, das insbesondere unter Verwendung einer wie vorstehend beschriebenen erfindungsgemäßen Anordnung durchgeführt werden kann. Dieses Verfahren ist durch folgende Schritte gekennzeichnet:

a) Messen der Zeitdauer einer Flanke einer von dem/den Treiber(n) an eine Last ausgegebenen Ausgangsspannung;
b) Umwandeln der gemessenen Zeitdauer einer Flanke der Ausgangsspannung in einen Ausgangsspannungswert;
c) Erzeugen eines von äußeren Bedingungen im wesentlichen unabhängigen Referenzspannungswerts;
d) Vergleichen des Ausgangsspannungswerts mit dem Referenzspannungswert; und
e) Anpassen des/der Treiber(s) in Abhängigkeit von den Vergleichsergebnissen.

Durch das erfindungsgemäße Verfahren kann der/die Treiber auf einfache Weise derart kalibriert werden, daß vom Anwender gewünschte und in weiten Grenzen wählbare Flankenzeiten weitgehend unabhängig von äußeren Bedingungen erreicht beziehungsweise eingestellt werden können. Zu den Vorteilen, Wirkungen, Effekten und der Funktionsweise des erfindungsgemäßen Verfahrens wird ebenfalls auf die vorstehenden Ausführungen zur erfindungsgemäßen Anordnung sowie zur erfindungsgemäßen Treiberschaltung vollinhaltlich Bezug genommen und hiermit verwiesen.

Vorteilhafte Ausführungsformen des Verfahrens ergeben sich aus den abhängigen Ansprüchen.

Das Grundprinzip des erfindungsgemäßen Verfahrens besteht darin, einen Referenzspannungswert, der der vom Anwender gewünschten und programmierbaren Flankenzeit entspricht, zu generieren. Dieser Referenzspannungswert wird mit einem tatsächlich gemessenen Ausgangsspannungswert verglichen. In Abhängigkeit von diesem Vergleichsergebnis wird der Treiber angepaßt.

Vorteilhaft kann die Zeitdauer einer Flanke der Ausgangsspannung gemessen werden, indem deren Anstiegszeit (rise time) und/oder deren Abfallzeit (fall time) gemessen wird.

Vorzugsweise kann die gemessene Zeitdauer einer Flanke der Ausgangsspannung in einer Vorrichtung zum Umwandeln in einen Ausgangsspannungswert konvertiert werden. Dies ist deshalb von Vorteil, da sich Spannungswerte wesentlich leichter und genauer vergleichen lassen, als es bei Zeitwerten möglich wäre.

Vorzugsweise kann die Vorrichtung zum Umwandeln der Zeitdauer einer Flanke der Ausgangsspannung eine Stromquelle, ein Schalterelement sowie eine Kapazität aufweisen, wobei die Zeitdauer einer Flanke der Ausgangsspannung in einen Ausgangsspannungswert konvertiert wird, indem das Schalterelement während eines vorgegebenen Zeitraums, insbesondere während der Anstiegszeit (rise time) und/oder der Abfallzeit (fall time) der Ausgangsspannung geschlossen wird, und daß während dieses Zeitraums die zuvor entladene Kapazität mittels der Stromquelle auf den Ausgangsspannungswert geladen wird.

In weiterer Ausgestaltung kann der Referenzspannungswert in einer Vorrichtung zum Erzeugen eines Referenzspannungswerts erzeugt werden, wobei die Vorrichtung eine Stromquelle, ein Schalterelement sowie eine Referenzkapazität aufweist, indem das Schalterelement über eine Einrichtung zum Vorgeben einer gewünschten, von äußeren Bedingungen im wesentlichen unabhän-gigen Flankenzeit für den/die Treiber für die Dauer eines von der Einrichtung vorgegebenen Spannungspulses, insbesondere eines Rechteckpulses, dessen Länge der gewünschten Flankenzeit entspricht, geschlossen wird, und wobei während dieses Zeitraums die zuvor entladene Referenzkapazität mittels der Stromquelle auf den Referenzspannungswert geladen wird.

Der Ausgangsspannungswert und der Referenzspannungswert können in einem Komparator verglichen werden, wobei auf Grund dieser Vergleichsergebnisse die Flankenzeit der an die Last ausgegebenen Ausgangsspannungen eingestellt wird.

Die einzelnen Verfahrensschritte können zur Erzeugung eines Regelzyklus wiederholt werden. In diesem Fall wird die Treiberstärke eines jeden Treibers jeweils um einen Takt verzögert angepaßt. Dies ist in der Regel jedoch nicht von Nachteil, da sich die äußeren Bedingungen üblicherweise nur langsam ändern.

Besonders vorteilhaft können eine wie vorstehend beschriebene erfindungsgemäße Anordnung zum Einstellen eines oder mehrerer Treiber und/oder eine wie vorstehend beschriebene erfindungsgemäße Treiberschaltung und/oder ein wie vorstehend beschriebenes erfindungsgemäßes Verfahren in Verbindung mit integrierten Schaltungen verwendet werden, wobei die einzelnen Treiber vorzugsweise als Padtreiber ausgebildet sind. Die Erfindung wird nun an Hand von Ausführungsbeispielen unter Bezugnahme auf die beiliegenden Zeichnungen näher erläutert. Es zeigen:

Figur 1     eine schematische Schaltungsanordnung einer erfindungsgemäßen Treiberschaltung;

Figur 2     eine schematische Schaltungsanordnung einer Einrichtung zum Vorgeben der gewünschten Flankenzeit für den/die Treiber gemäß der vorliegenden Erfindung; und

Figur 3     eine schematische Schaltungsanordnung eines aus mehreren Teiltreibern bestehenden skalierbaren Treibers.

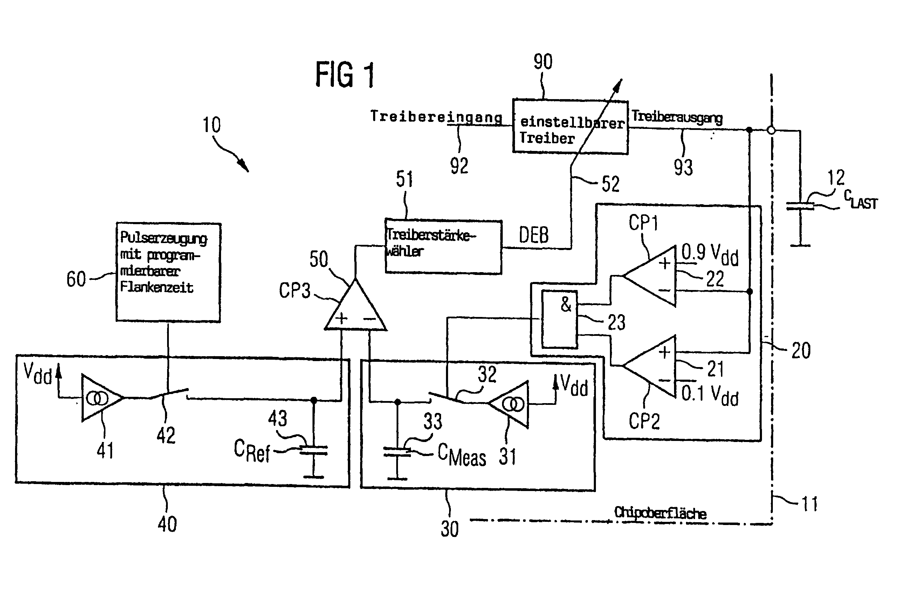

In Figur 1 ist eine Treiberschaltung dargestellt, die beispielsweise als Treiberschaltung für Padtreiber integrierter Schaltungen auf einem Chip 11 angeordnet ist. Die Treiberschaltung weist zunächst einen einstellbaren Treiber 90 auf, der über einen Treibereingang-Input 92 sowie einen Treiberausgang-Output 93 verfügt. Der Treiber 90 ist über den Treiberausgang-Output 93 mit einer Last, im vorliegenden Fall einer Lastkapazität 12, verbunden. Der besseren Übersicht halber ist in Figur 1 nur ein einziger Treiber 90 dargestellt.

Der Treiber 90 ist über eine Steuerleitung (driver-enable-bus, DEB) mit einer Vorrichtung 51 zum Auswählen der Treiberstärke verbunden, die als "driver strength selector" bezeichnet ist.

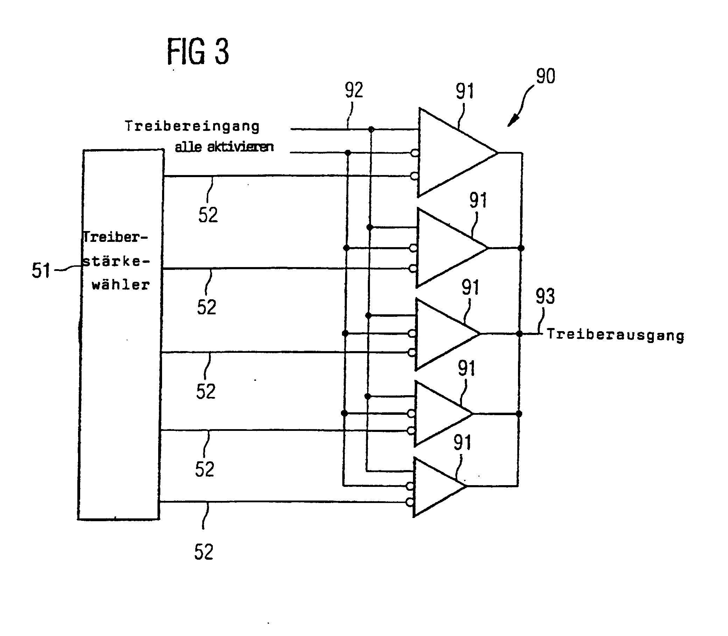

Wie in Figur 3 dargestellt ist, kann der einstellbare Treiber 90 aus einer Anzahl von Teiltreibern 91 bestehen. Jeder Teiltreiber 91 ist über eine Steuerleitung 52 mit dem "driver strength selector" 51 verbunden.

Aus Figur 1 ist ersichtlich, daß der "driver strength selector" 51 Bestandteil einer Anordnung 10 zum Einstellen der Flankenzeiten eines oder mehrerer Treiber 90 ist. Die Anordnung 10 weist zunächst eine Vorrichtung 20 zum Erfassen der zeitlichen Veränderung einer Ausgangsspannung auf, die im vorliegenden Ausführungsbeispiel als Fensterkomparator ausgebildet ist. Der Fensterkomparator 20 ist zum einen mit dem Treiberausgang-Output 93 verbunden.

Der Fensterkomparator 20 weist zwei Spannungskomparatoren CP1 und CP2 auf, die mit den Bezugsziffern 21 und 22 bezeichnet sind. Die beiden Spannungskomparatoren 21, 22 sind über ein UND-Glied 23 miteinander verbunden.

Weiterhin weist die Anordnung 10 eine Vorrichtung 30 zum Erzeugen eines Ausgangsspannungswerts auf. Die Vorrichtung 30 verfügt über eine Stromquelle 31, ein Schalterelement 32 sowie eine Kapazität Cmeas, die mit dem Bezugszeichen 33 bezeichnet ist. Das Schalterelement 32 kann über Signale betätigt werden, die vom Fensterkomparator 20 ausgegeben werden.

Darüber hinaus weist die Anordnung 10 eine Vorrichtung 40 zum Erzeugen eines Referenzspannungswerts auf. Diese Vorrichtung 40 verfügt über eine Stromquelle 41, ein Schalterelement 42 sowie eine Referenzkapazität 43. Das Schalterelement 42 kann über Signale einer Einrichtung 60 zum Vorgeben einer gewünschten Flankenzeit betätigt werden.

Die beiden Vorrichtungen 30, 40 zum Erzeugen des Ausgangsspannungswerts beziehungsweise des Referenzspannungswerts sind mit einem Spannungskomparator CP3 verbunden, der mit der Bezugsziffer 50 bezeichnet ist. Der Spannungskomparator 50 ist ebenfalls mit dem "driver strength selector" 51 verbunden.

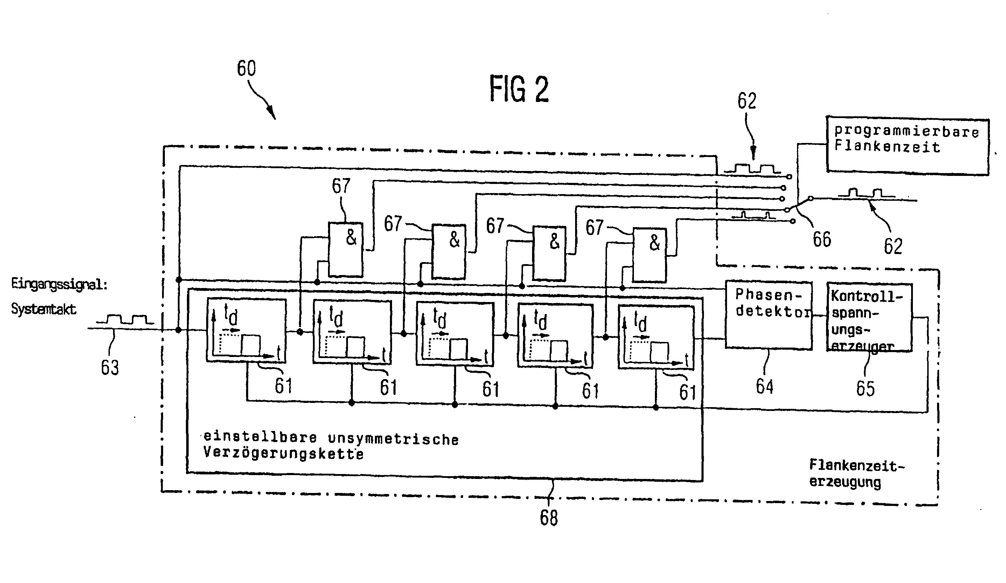

Die in Figur 1 dargestellte Einrichtung 60 zum Vorgeben einer gewünschten Flankenzeit ist in Figur 2 näher beschrieben. Sie verfügt über eine Anzahl von Verzögerungsgliedern 61, die ein Eingangssignal, im vorliegenden Fall einen Systemtakt 63, in Rechteckpulse 62 mit unterschiedlichen Pulslängen umwandeln.

Die einzelnen Verzögerungsglieder 61 sind zu einer Verzögerungskette 68 zusammengefaßt. Zur Umwandlung der Spannungspulse, die im Hinblick auf die Funktionsweise der erfindungsgemäßen Anordnung 10 näher erläutert wird, ist weiterhin ein Phasendetektor 64 sowie eine Vorrichtung 65 zum Erzeugen einer Kontrollspannung vorgesehen. Darüber hinaus verfügt die Einrichtung 60 über eine Anzahl von UND-Gliedern 67. Die Auswahl eines gewünschten Rechteckpulses 62, der der gewünschten Flankenzeit entspricht, erfolgt über ein Schalterelement 66, das beispielsweise als Multiplexer ausgebildet sein kann.

Nachfolgend wird nun die Funktionsweise der erfindungsgemäßen Anordnung 10 zum Einstellen der Flankenzeiten eines oder mehrerer Treiber 90 im wesentlichen unabhängig von äußeren Bedingungen beschrieben.

Das Grundprinzip der erfindungsgemäßen Anordnung besteht darin, einen Rechteckpuls 62, dessen Länge der gewünschten und vom Anwender der Anordnung 10 programmierbaren Flankenzeit entspricht, zu generieren. Die Pulslänge des Rechteckpulses 62 wird mit der tatsächlichen Flankenzeit verglichen und abhängig vom Ergebnis wird der skalierbare Treiber 90 angepaßt. Der skalierbare Treiber 90 besteht aus einer Anzahl paralleler Teiltreiber 91, die mittels Steuerleitungen 52 individuell freigegeben oder gesperrt werden können. Wechselt der Treibereingang-Input 92 seinen Zustand, schalten entsprechend alle freigegebenen Teiltreiber 91 und laden, beziehungsweise entladen, über den Treiberausgang-Output 93 die angeschlossene Lastkapazität 12. Im folgenden wird davon ausgegangen, daß zum Zeitpunkt t=0 das Treibereingangssignal von "low" nach "high" wechselt, das heißt die zuvor entladene Lastkapazität 12 soll im weiteren Zeitverlauf auf eine Betriebsspannung Vdd geladen werden.

Nach der Aktivierung der in diesem Moment freigegebenen Teiltreiber 91 wird die Ausgangsspannung am Treiberausgang ansteigen, bis die Betriebsspannung Vdd erreicht ist. Dieser zeitliche Verlauf wird durch den Fensterkomparator 20, bestehend aus den beiden Spannungskomparatoren 21 und 22 sowie dem UND-Glied 23 überwacht. Der Ausgang des Fensterkomparators schaltet genau während der Anstiegszeit des Spannungssignals "high", wobei die Anstiegszeit diejenige Zeit ist, die das Spannungssignal benötigt, um von 10% auf 90% der Endspannung zu gelangen.

Nun erfolgt eine Konvertierung der Zeit in einen Spannungswert, in dem der Schalter 32 der Vorrichtung 30 während des "high"-Zustands des Fensterkomparators 20 geschlossen wird, wodurch die zuvor entladene Meßkapazität 33 mittels der Stromquelle 31 auf einen Ausgangsspannungswert (Vmeas) geladen wird. Über eine gleichartige Struktur der Vorrichtung 40 mit Stromquelle 41, Schalterelement 42 und Referenzkapazität 43 wird die Referenzkapazität 43 auf einen Referenzspannungswert (Vref) geladen. Die Dauer während der das Schalterelement 42 geschlossen ist, wird über die Einrichtung 60 vom Anwender vorgegeben und entspricht der gewünschten Anstiegszeit (Flankenzeit).

Der Spannungskomparator 50 vergleicht sodann den Ausgangsspannungswert mit dem Referenzspannungswert. Wenn Vmeas < Vref gilt, wurde die Kapazität 33 für den Ausgangsspannungswert kürzer geladen als die Referenzkapazität 43, die tatsächliche Anstiegszeit war demnach kürzer als die gewünschte. Der Komparator 50 wird dies durch die Ausgabe eines "high"-Pegels anzeigen, wodurch die Treiberfähigkeit des einstellbaren Treibers 90 durch den "driver strength selector" 51 reduziert wird. Für den Fall Vmeas > Vref gilt analoges. Bei der nächsten steigenden Flanke beginnt der Regelzyklus von neuem, so daß der Treiber 90 sukzessive an die Last 12 und die gewünschte Flankenzeit angepaßt wird.

Wesentlich für die Güte der Regelung ist die exakte Generierung der gewünschten Flankenzeit. Sie darf nicht von äußeren Bedingungen abhängen. Aus diesem Grund wird, wie dies in Figur 2 dargestellt ist, ein Systemtakt 63, der bei Mikrocontrollern, Mikroprozessoren oder dergleichen vorhanden ist, genutzt. Der Systemtakt 63 kann als konstant bezüglich äußerer Bedingungen angenommen werden.

Eingangssignal ist der relativ niederfrequente Systemtakt 63, der eine Kette 68 von Verzögerungsgliedern 61 durchläuft. Jedes Verzögerungsglied 61 verzögert die Ausgabe der steigenden Flanke seines Eingangs, abhängig von der in der Vorrichtung 65 erzeugten Kontrollspannung. Der Phasendetektor 64 überprüft, ob die fallende Flanke des Eingangssignals 63 zeitgleich mit der verzögert ausgegebenen steigenden Flanke am Ausgang der Verzögerungskette 68 auftritt. Ist dies nicht der Fall, wird abhängig davon, welcher Pegelwechsel zuerst stattfand, die Kontrollspannung in der Vorrichtung 65 derart geändert, daß im nächsten Zyklus die Phasendifferenz kleiner wird. Die fallende Flanke des Eingangssignals 63 kann nahezu unverzögert durch die Verzögerungskette 68 geleitet werden.

Wird das Eingangssignal 63 jeweils mit dem Ausgang eines jeden Verzögerungsglieds 61 über entsprechende UND-Glieder 67 verknüpft, stehen, mit dem Eingangssignal 63 selbst, n parallele Signale in Form von Rechteckpulsen 62 an. Mittels des als Multiplexer ausgebildeten Schalterelements 66 wählt der Anwender davon ein Signal aus, das dann als Rechteckpuls 62 zur Erzeugung des Referenzspannungswerts verwendet wird.

Auf diese Weise können Flankenzeiten im wesentlichen unabhängig von äußeren Bedingungen eingestellt werden. Weiterhin ist von Vorteil, daß zwischen der gewählten Ausgangspulsdauer 62 und der Systemtaktfrequenz 63 immer ein fester und eindeutiger Zusammenhang besteht.

Um die auf einem Chip 11 zur Verfügung stehende Fläche optimal nutzen zu können, können jeweils mehrere Treiber 90 mit ein und derselben Anordnung 10 zum Einstellen der Flankenzeiten verbunden sein. Die Treiber 90 können über entsprechende Schalterelemente, beispielsweise Multiplexer, mit der Anordnung 10 verbunden sein, so daß die Treiber 90 nacheinander eingeregelt werden können. Die jeweiligen, optimalen Treiberstärken können in einer geeigneten, nicht dargestellten Speichereinrichtung zwischengespeichert werden.

**Patentansprüche**

1. Anordnung zum Einstellen der Flankenzeiten eines oder mehrerer Treiber (90) im wesentlichen unabhängig von äußeren Bedingungen, mit einer Vorrichtung (20) zum Erfassen der Zeitdauer einer Flanke einer von dem/den Treiber(n) (90) an eine Last (12) ausgegebenen Au6gangsspannung, einer Vorrichtung (30) zum Umwandeln der gemessenen Zeitdauer einer Flanke der Ausgangsspannung in einen Ausgangsspannungswert, einer Vorrichtung (40) zum Erzeugen eines Referenzspannungswerts, einer Einrichtung (60) zum Vorgeben einer gewünschten, von äußeren Bedingungen im wesentlichen unabhängigen Flankenzeit für den/die Treiber (90), die mit der Vorrichtung (40) zum Erzeugen eines Referenzspannungswerts verbunden ist, und einer Einrichtung (50) zum Vergleichen des Ausgangsspannungswerts mit dem Referenzspannungswert, wobei die Vergleichseinrichtung (50) mit dem/den Treiber(n) (90) verbunden oder verbindbar ist.

2. Anordnung nach .Anspruch 1,
**dadurch gekennzeichnet,**
**daß** die Vorrichtung (20). zum Erfassen der Zeitdauer einer Flanke der von dem/den Treiber(n) (90) an eine Last (12) ausgegebenen Ausgangsspannung als Fensterkomparator ausgebildet ist.

3. Anordnung nach Anspruch 2,
**dadurch gekennzeichnet,**
**daß** der Fensterkomparator (20) zwei Spannungskomparatoren (21, 22) aufweist, die mit einem UND-Glied (23) verbunden sind.

4. Anordnung nach einem der Ansprüche 1 bis 3,
**dadurch gekennzeichnet,**
**daß** die Vorrichtung (30) zum Umwandeln der gemessenen Zeitdauer einer Flanke der Ausgangsspannung in einen Ausgangsspannungswert eine Stromquelle (31), ein Schalterelement (32) und eine Kapazität (33) aufweist, wobei das Schalterelement (32) über Signale der Vorrichtung (20) zum Erfassen der Zeitdauer einer Flanke der von dem/den Treiber (n) (90) an eine Last (12) ausgegebenen Ausgangsspannung betätigt wird oder betätigbar ist.

5. Anordnung nach einem der Ansprüche 1 bis 4,
**dadurch gekennzeichnet,**
**daß** die Vorrichtung (40) zum Erzeugen eines Referenzspannungswerts eine Stromquelle (41), ein Schalterelement (42) und eine Referenzkapazität. (43) aufweist, wobei das Schalterelement (42) über Signale der Einrichtung (60) zum Vorgeben einer gewünschten Flankenzeit für den/die Treiber (90) betätigt wird oder betätigbar ist.

6. Anordnung nach einem der Ansprüche 1 bis 5,
**dadurch gekennzeichnet,**
**daß** die Einrichtung (50) zum Vergleichen des Ausgangsspannungswerts mit dem Referenz spannungswert als Komparator ausgebildet ist.

7. Anordnung nach einem der Ansprüche .1 bis 6,
**dadurch gekennzeichnet,**
**daß** eine Vorrichtung (51) zum Auswählen der Treiberstärke vorgesehen ist, daß die Vorrichtung (51) mit der Einrichtung (50) zum Vergleichen des Ausgangsspannungswerts mit dem Referenzspannungswert verbunden ist und daß die Vorrichtung (51) zum Auswählen der Treiberstärke weiterhin mit dem/den Treiber (n) (90) verbunden oder, verbindbar ist.

8. Anordnung nach einem der Ansprüche 1 bis 7,
**dadurch gekennzeichnet,**
**daß** die Einrichtung (60) zum Vorgeben der gewünschten Flankenzeit für den/die Treiber (90) zum Erzeugen eines Rechteckpulses (62), dessen Länge der gewünschten Flankenzeit entspricht, ausgebildet ist.

9. Anordnung nach einem der Ansprüche 1 bis 8,
**dadurch gekennzeichnet,**
**daß** die Einrichtung (60) zum Vorgeben der gewünschten
Flankenzeit für den/die-Treiber (90) zur Verarbeitung eines Systemtakts (63) ausgebildet ist.

10. Anordnung nach einem der Ansprüche bis 9,
**dadurch gekennzeichnet,**
**daß** die Einrichtung (60) zum Vorgeben der gewünschten Flankenzeit für den/die Treiber (90) ein oder mehrere Verzögerungsglieder (61) aufweist.

11. Anordnung nach einem der Ansprüche 1 bis 10,
**dadurch gekennzeichnet,**
**daß** Einrichtung (60) zum Vorgeben der gewünschten Flankenzeit für den/die Treiber (90) wenigstens einen Phasendetektor (64) aufweist.

12. Anordnung nach einem der Ansprüche 1 bis 11,
**dadurch gekennzeichnet,**
**daß** Einrichtung (60) zum Vorgeben der gewünschten Flankenzeit für den/die Treiber (90) wenigstens eine Vorrichtung (65) zum Erzeugen einer Kontrollspannung aufweist.

13. Anordnung nach einem der Ansprüche 1 bis 12,
**dadurch gekennzeichnet,**
**daß** Einrichtung (60) zum Vorgeben der gewünschten Flankenzeit für den/die Treiber (90) wenigstens ein Schalterelement (66), insbesondere einen Multiplexer, zum Umschalten zwischen verschiedenen Flankenzeitsignalen aufweist.

14. Treiberschaltung zum Treiben einer Last, mit einem oder mehrereh Treiber (n) (90), der/die mit der Last (12) verbunden ist/sind,
**dadurch gekennzeichnet,**
**daß** der/die Treiber (90) mit einer Anordnung (10) zum Einstellen der Flankenzeiten nach einem der Ansprüche 1 bis_13 verbunden ist/sind.

15. Treiberschaltung nach Anspruch 14,
**dadurch gekennzeichnet, daß** der/die Treiber (90) als skalierbare(r) Treiber ausgebildet ist/sind.

16. Treiberschaltung nach Anspruch 15, **dadurch gekennzeichnet,** **daß** der/die Treiber .(90) jeweils einen oder mehrere Teiltreiber (91) aufweist/aufweisen.

17. Treiberschaltung nach einem der Ansprüche 14 bis 16, **dadurch gekennzeichnet,** **daß** jeweils ein oder mehrere Treiber (90) mit einer Anordnung (10) zum Einstellen der Flankenzeiten verbunden ist/sind.

18. Treiberschaltung nach Anspruch 17, bei der mehrere Treiber (90) mit einer Anordnung (10) zum Einstellen der Flankenzeiten verbunden sind, **dadurch gekennzeichnet,** **daß** die Treiber (90) über ein Schalterelement, insbesondere einen Multiplexer, mit der Anordnung (10) verbunden sind.

19. Treiberschaltung nach einem der Ansprüche 14 bis 18, **dadurch gekennzeichnet,** **daß** die Last (12) als kapazitive Last ausgebildet ist.

20. Verfahren zum Einstellen der Flankenzeiten eines oder mehrerer Treiber im wesentlichen unabhängig von äußeren Bedingungen, insbesondere unter Verwendung einer Anordnung nach einem der Ansprüche 1 bis 13, **gekennzeichnet durch** folgende Schritte:

a) Messen der Zeitdauer einer Flanke einer von dem/den Treiber(n) an eine Last ausgegebenen Ausgangsspannung;
b) Umwandeln der gemessenen Zeitdauer einer Flanke der Ausgangsspannung in einen Ausgangsspannungswert;
c.) Erzeugen eines von äußeren Bedingungen im wesentlichen unabhängigen Referenzspannungswerts;
d) Vergleichen des Ausgangsspannungswerts mit dem Referenzspannungswert; und
e) Anpassen des/der Treiber(s)in Abhängigkeit von den Vergleichsergebnissen.

21. Verfahren nach Anspruch 20, **dadurch gekennzeichnet,** **daß** der zeitliche Verlauf der Ausgangsspannung gemessen wird, indem deren Anstiegszeit (rise time) und/oder deren Abfallzeit (fall time) gemessen wird.

22. Verfahren nach'Anspruch 20 oder 21, **dadurch gekennzeichnet,**

**daß** der gemessene zeitliche Verlauf der Ausgangsspannung in einer Vorrichtung zum Umwandeln in einen Ausgangsspannungswert konvertiert wird.

23. Verfahren nach Anspruch 22, **dadurch gekennzeichnet, daß** die Vorrichtung zum Umwandeln der Zeitdauer einer Flanke der Ausgangsspannung eine Stromquelle, ein Schalterelement sowie eine Kapazität aufweist und daß der zeitliche Verlauf der Ausgangsspannung in einen Ausgangsspannungswert konvertiert wird, indem däs Schalterelement während eines vorgegeben Zeitraums, insbesondere während der Anstiegszeit (rise time) und/oder der Abfallzeit (fall time) der Ausgangsspannung, geschlossen wird, und daß während dieses Zeitraums die zuvor entladene Kapazität mittels der. Stromquelle auf den Ausgangsspannungswert geladen wird.

24. Verfahren nach einem der Ansprüche 20 bis 23, **dadurch gekennzeichnet,** **daß** der Referenzspannungswert in einer Vorrichtung zum Erzeugen eines Referenzspannungswerts erzeugt wird, wobei die Vorrichtung eine Stromquelle, ein Schalterelement sowie eine Referenzkapazität aufweist, indem das Schalterelement über eine Einrichtung zum Vorgeben einer gewünschten, von äußeren Bedingungen im wesentlichen unabhängigen Flankenzeit für den/die Treiber für die Dauer eines von der Einrichtung vorgegebenen Spannungspulses, insbesondere eines Rechteckpulses; dessen Länge der gewünschten Flankenzeit entspricht geschlossen wird, und daß während dieses Zeitraums die zuvor entladene Referenzkapazität mittels der Stromquelle auf den Referenzspannungswert geladen- wird.

25. Verfahren nach einem der Ansprüche 20 bis 24, **dadurch gekennzeichnet,** **daß** der Ausgangsspannungswert und der Referenz spannungswert in einem Komparator verglichen werden und daß aufgrund dieser Vergleicbsergebnisse die Flankenzeit der an die Last ausgegebenen Ausgangsspannung eingestellt wird.

26. Verfahren nach einem der Ansprüche 20 bis 25, **dadurch gekennzeichnet;** **daß** die einzelnen Verfahrensschritte zur Erzeugung eines Regelzyklus wiederholt werden.

27. Verwendung einer Anordnung nach einem der Ansprüche 1 bis 13 zum Einstellen eines oder mehrerer Treiber, insbesondere eines oder mehrerer Padtreiber, integrierter Schaltungen.

28. Verwendung einer Treiberschaltung nach einem der Ansprüche 14 bis 19 als Treiber, insbesondere als Padtreiber, integrierter Schaltungen.

29. Verwendung eines Verfahrens nach einem der Ansprüche 20 bis 26 zum Einstellen eines oder mehrerer Treiber, insbesondere eines oder mehrerer Padtreiber, integrierter. Schaltungen.

**Claims**

1. An arrangement for adjustment of the slope times for one or more drivers (90) essentially independently of external conditions, having an apparatus (20) for recording the time duration of a slope of an output voltage which is emitted from the driver or drivers (90) to a load (12), having an apparatus (30) for conversion of the measured time duration of a slope of the output voltage to an output voltage value, having an apparatus (40) for production of a reference voltage value, having a device (60) for presetting a desired slope time, which is essentially independent of external conditions, for the driver or drivers (90), which device (60) is connected to the apparatus (40) for production of a reference voltage value, and having a device (50) for comparison of the output voltage value with the reference voltage value, wherein the comparison device (50) is or can be connected to the driver or drivers (90) .

2. The arrangement as claimed in claim 1, **characterized in that** the apparatus (20) for recording the time duration of a slope of the output voltage which is emitted from the driver or drivers (90) to a load (12) is in the form of a window comparator.

3. The arrangement as claimed in claim 2, **characterized in that** the window comparator (20) has two voltage comparators (21, 22) which are connected to an AND gate (23).

4. The arrangement as claimed in any one of claims 1 to 3, **characterized in that** the apparatus (30) for conversion of the measured time duration of a slope of the output voltage to an output voltage value has a current source (31), a switch element (32) and a capacitance (33), wherein the switch element (32) is operated or can be operated via signals from the apparatus (20) for recording the time duration of a slope of the output voltage which is emitted from the driver or drivers (90) to a load (12).

5. The arrangement as claimed in any one of claims 1 to 4, **characterized in that** the apparatus (40) for production of a reference voltage value has a current source (41), a switch element (42) and a reference capacitance (43), wherein the switch element (42) is operated or can be operated via signals from the device (60) for presetting a desired slope time for the driver or drivers (90).

6. The arrangement as claimed in any one of claims 1 to 5, **characterized in that** the device (50) for comparison of the output voltage value with the reference voltage value is in the form of a comparator.

7. The arrangement as claimed in any one of claims 1 to 6, **characterized in that** an apparatus (51) is provided for selection of the driver strength, **in that** the apparatus (51) is connected to the device (50) for comparison of the output voltage value with the reference voltage value, and **in that** the apparatus (51) for selection of the driver strength is or can be connected to the driver or drivers (90) as well.

8. The arrangement as claimed in any one of claims 1 to 7, **characterized in that** the device (60) for presetting the desired slope time for the driver or drivers (90) is designed for production of a square-wave pulse (62), whose length corresponds to the desired slope time.

9. The arrangement as claimed in any one of claims 1 to 8, **characterized in that** the device (60) for presetting the desired slope time for the driver or drivers (90) is designed for processing a system clock (63).

10. The arrangement as claimed in any one of claims 1 to 9, **characterized in that** the device (60) for presetting the desired slope time for the driver or drivers (90) has one or more delay elements (61).

11. The arrangement as claimed in any one of claims 1 to 10, **characterized in that** the device (60) for presetting the desired slope time for the driver or drivers (90) has at least one phase detector (64).

12. The arrangement as claimed in any one of claims 1 to 11,

**characterized in that**
the device (60) for presetting the desired slope time for the driver or drivers (90) has at least one apparatus (65) for production of a control voltage.

13. The arrangement as claimed in any one of claims 1 to 12,
**characterized in that**
the device (60) for presetting the desired slope time for the driver or drivers (90) has at least one switch element (66), in particular a multiplexer, for switching between different slope time signals.

14. A driver circuit for driving a load, having one or more drivers (90) which is or are connected to the load (12),
**characterized in that**
the driver or drivers (90) is or are connected to an arrangement (10) for adjustment of the slope times as claimed in any one of claims 1 to 13.

15. The driver circuit as claimed in claim 14,
**characterized in that**
the driver or drivers (90) is or are in the form of a scalable driver or scalable drivers.

16. The driver circuit as claimed in claim 15,
**characterized in that**
the driver or drivers (90) each has or have one or more partial driver elements (91).

17. The driver circuit as claimed in any one of claims 14 to 16,
**characterized in that**
one or more drivers (90) is or are each connected to an arrangement (10) for adjustment of the slope times.

18. The driver circuit as claimed in claim 17, in which a number of drivers (90) are connected to an arrangement (10) for adjustment of the slope times,
**characterized in that**
the drivers (90) are connected to the arrangement (10) via a switch element, in particular a multiplexer.

19. The driver circuit as claimed in any one of claims 14 to 18,
**characterized in that**
the load (12) is in the form of a capacitive load.

20. A method for adjustment of the slope times for one or more drivers essentially independently of external conditions, in particular using an arrangement as claimed in any one of claims 1 to 13,
**characterized by** the following steps:

a) measuring the time duration of a slope of an output voltage which is emitted from the driver or drivers to a load;
b) converting the measured time duration of a slope of the output voltage to an output voltage value;
c) producing a reference voltage value which is essentially independent of external conditions;
d) comparing the output voltage value with the reference voltage value; and
e) matching the driver or drivers as a function of the comparison results.

21. The method as claimed in claim 20,
**characterized in that**
the time profile of the output voltage is measured by measuring its rise time and/or its fall time.

22. The method as claimed in claim 20 or 21,
**characterized in that**
the measured time profile of the output voltage is converted inside an apparatus for conversion to an output voltage value.

23. The method as claimed in claim 22,
**characterized in that**
the apparatus for conversion of the time duration of a slope of the output voltage has a current source, a switch element and a capacitance, and **in that** the time profile of the output voltage is converted to an output voltage value by closing the switch element during a predetermined time period, in particular during the rise time and/or the fall time of the output voltage, and **in that**, during this time period, the previously discharged capacitance is charged by means of the current source to the output voltage value.

24. The method as claimed in any one of claims 20 to 23,
**characterized in that**
the reference voltage value is produced in an apparatus for production of a reference voltage value, wherein the apparatus has a current source, a switch element and a reference capacitance, by the switch element being closed via a device for presetting a desired slope time, which is essentially independent of external conditions, for the driver or drivers for the duration of a voltage pulse, in particular a square-wave pulse, which is preset by the device and whose length corresponds to the desired slope time, and **in that**, during this time period, the previously discharged reference capacitance is charged by means of the current source to the reference voltage value.

25. The method as claimed in any one of claims 20 to 24,
**characterized in that**
the output voltage value and the reference voltage value are compared in a comparator, and **in that** the slope time of the output voltage which is emitted to the load is adjusted on the basis of these comparison results.

26. The method as claimed in any one of claims 20 to 25,
**characterized in that**
the individual method steps are repeated in order to produce a regulate cycle.

27. Use of an arrangement as claimed in any one of claims 1 to 13 for adjustment of one or more drivers, in particular of one or more pad drivers, for integrated circuits.

28. Use of a driver circuit as claimed in any one of claims 14 to 19 as a driver, in particular as a pad driver, for integrated circuits.

29. Use of a method as claimed in any one of claims 20 to 26 for adjustment of one or more drivers, in particular of one or more pad drivers, for integrated circuits.

**Revendications**

1. Dispositif pour régler les durées des flancs de signaux d'un ou de plusieurs étages d'attaque (90) d'une manière essentiellement indépendante de conditions extérieures, comportant un dispositif (20) pour détecter la durée d'un flanc d'une tension de sortie délivrée par le ou les étages d'attaque (90) à une charge (12), un dispositif (30) pour convertir la durée mesurée d'un flanc de la tension de sortie en une valeur de tension de sortie, un dispositif (40) pour produire une valeur de tension de référence, un dispositif (60) pour prédéterminer une durée désirée de flanc, essentiellement indépendante de conditions extérieure pour le ou les étages d'attaque (90), et qui est relié au dispositif (40) pour produire une valeur de tension de référence, et un dispositif (50) pour comparer la valeur de tension de sortie à une valeur de tension de référence, le dispositif comparateur (50) étant relié ou pouvant être relié à ou aux étages d'attaque (90).

2. Dispositif selon la revendication 1, **caractérisé en ce que** le dispositif (20) servant à détecter la durée d'un flanc de la tension de sortie délivrée par le ou les étages d'attaque (90) à une charge (12) est agencé sous la forme d'un comparateur à fenêtre.

3. Dispositif selon la revendication 2, **caractérisé en ce que** le comparateur à fenêtre (20) comporte deux comparateurs de tension (21, 22), qui sont reliés à un circuit ET (23).

4. Dispositif selon l'une des revendications 1 à 3, **caractérisé en ce que** le dispositif (30) servant à convertir la durée mesurée d'un flanc de la tension de sortie en une valeur de tension de sortie comporte une source de courant (31), un élément de commutation (32) et une capacité (33), l'élément de commutation (32) étant ou pouvant être actionné par l'intermédiaire de signaux du dispositif (20) pour détecter la durée d'un flanc de la tension de sortie délivrée par le ou les étages d'attaque (90) à une charge (12).

5. Dispositif selon l'une des revendications 1 à 4, **caractérisé en ce que** le dispositif (40) servant à produire une valeur de tension de référence comporte une source de courant (41) et un élément de commutation (42) et une capacité de référence (43), l'élément de commutation (42) étant ou pouvant être actionné par l'intermédiaire de signaux du dispositif (60) pour prédéterminer une durée désirée de flanc pour le ou les étages d'attaque (90).

6. Dispositif selon l'une des revendications 1 à 5, **caractérisé en ce que** le dispositif (50) pour comparer la valeur de la tension de sortie à la valeur de la tension de référence est agencé sous la forme d'un comparateur.

7. Dispositif selon l'une des revendications 1 à 6, **caractérisé en ce qu'**il est prévu un dispositif (51) pour sélectionner la puissance de l'étage d'attaque, que le dispositif (51) est relié au dispositif (50) servant à comparer la valeur de tension de sortie à la valeur de tension de référence et que le dispositif (51) pour la sélection de la puissance de l'étage d'attaque est ou peut être relié en outre à l'étage d'attaque ou aux étages d'attaque (90).

8. Dispositif selon l'une des revendications 1 à 7, **caractérisé en ce que** le dispositif (60) servant à prédéterminer la valeur désirée de flanc pour le ou les étages d'attaque (90) est conçue pour la production d'une impulsion rectangulaire (62), dont la longueur correspond à la durée désirée de flanc.

9. Dispositif selon l'une des revendications 1 à 8, **caractérisé en ce que** le dispositif (60) servant à prédéterminer la durée désirée de flanc ou le ou les étages d'attaque (90) est agencé pour le traitement d'une cadence (63) du système.

10. Dispositif selon l'une des revendications 1 à 9, **caractérisé en ce que** le dispositif (60) pour la prédétermination de la durée désirée de flanc ou le ou les étages d'attaque (90) possède un ou plusieurs circuits de retardement (61).

11. Dispositif selon l'une des revendications 1 à 10, **ca-**

**ractérisé en ce que** le dispositif (60) pour la prédétermination de la durée désirée des flancs pour le ou les étages d'attaque (90) comporte au moins un détecteur de phase (64).

**12.** Dispositif selon l'une des revendications 1 à 11, **caractérisé en ce que** le dispositif (60) servant à prédéterminer la durée désirée de flanc pour le ou les étages d'attaque (90) comporte au moins un dispositif (65) pour produire une tension de contrôle.

**13.** Dispositif selon l'une des revendications 1 à 12, **caractérisé en ce que** le dispositif (60) servant à prédéterminer la durée de flanc désirée ou le ou les étages d'attaque (90) possède au moins un élément de commutation (66), notamment un multiplexeur, pour réaliser une commutation entre différents signaux de durée de flanc.

**14.** Circuit d'attaque pour commander une charge, comportant un ou plusieurs étages d'attaque (90), qui est/sont relié(s) à la charge (12), **caractérisé en ce que** le ou les étage d'attaque est/sont relié(s) à un dispositif (10) servant à régler les durées des flancs selon l'une des revendications 1 à 13.

**15.** Circuit d'attaque selon la revendication 14, **caractérisé en ce que** le ou les étage(s) d'attaque (90) est/sont agencé(s) sous la forme d'étages d'attaque pouvant être soumis à un cadrage d'échelle.

**16.** Circuit d'attaque selon la revendication 15, **caractérisé en ce que** le ou les étages d'attaque (90) comportent chacun un ou plusieurs étages d'attaque partiels (91).

**17.** Circuit d'attaque selon l'une des revendications 14 à 16, **caractérisé en ce que** respectivement plusieurs étages d'attaque (90) est/sont relié(s) à un dispositif (10) pour le réglage des durées des flancs.

**18.** Circuit d'attaque selon la revendication 17, dans lequel plusieurs étages d'attaque (90) sont reliés à un dispositif (10) pour le réglage des durées des flancs, **caractérisé en ce que** les étages d'attaque (90) sont reliés au dispositif (10) par l'intermédiaire d'un élément de commutation, notamment un multiplexeur.

**19.** Circuit d'attaque selon l'une des revendications 14 à 18, **caractérisé en ce que** la charge (12) est agencée sous la forme d'une charge capacitive.

**20.** Procédé pour régler les durées des flancs d'un ou de plusieurs étages d'attaque d'une manière essentiellement indépendante de conditions extérieures, notamment moyennant l'utilisation d'un dispositif selon l'une des revendications 1 à 13, **caractérisé par** les étapes opératoires suivantes:

    a) mesure de la durée d'un flanc d'une tension de sortie délivré par le ou les étages d'attaque à une charge;
    b) conversion de la durée mesurée d'un flanc de la tension de sortie en une valeur de tension de sortie;
    c) production d'une valeur de tension de référence essentiellement indépendante de conditions extérieures;
    d) comparaison de la valeur de tension de sortie à la valeur de tension de référence; et
    e) adaptation du ou des étages d'attaque en fonction des résultats de la comparaison.

**21.** Procédé selon la revendication 20, **caractérisé en ce qu'**on mesure la variation dans le temps de la tension de sortie par le fait qu'on mesure son temps de montée (rise time) et/ou son temps de retombée (fall time).

**22.** Procédé selon la revendication 20 ou 21, **caractérisé en ce que** la variation dans le temps mesurée de la tension de sortie est convertie dans un dispositif de conversion en une valeur de tension de sortie.

**23.** Procédé selon la revendication 22, **caractérisé en ce que** le dispositif servant à convertir la durée d'un flanc de la tension de sortie comporte une source de courant, un élément de commutation ainsi qu'une capacité, et que la variation dans le temps de la tension de sortie est convertie en une valeur de tension de sortie, par le fait que l'élément de commutation est fermé pendant un intervalle de temps prédéterminé, notamment pendant le temps de montée (rise time) et/ou pendant le temps de retombée (fall time) de la tension de sortie, et que pendant cet intervalle de temps, la capacité déchargée auparavant est chargée au moyen de la source de courant à la valeur de tension de sortie.

**24.** Procédé selon l'une des revendications 20 à 23, **caractérisé en ce que** la valeur de tension de référence est produite dans un dispositif servant à produire une valeur de tension de référence, le dispositif comportant une source de courant et un élément de commutation ainsi qu'une capacité de référence, par le fait que l'élément de commutation est fermé par l'intermédiaire d'un dispositif servant à déterminer une durée désirée de flanc, essentiellement indépendante de conditions extérieures pour le ou les étages d'attaque pendant la durée d'une impulsion de tension prédéterminée par le dispositif, notamment d'une impulsion rectangulaire, dont la longueur correspond à la durée désirée de flanc, et que pendant cet intervalle de temps, la capacité de référence déchargée auparavant est chargée au moyen de la source de courant à la valeur de tension de référence.

25. Procédé selon l'une des revendications 1 à 24, **caractérisé en ce que** la valeur de tension de sortie et la valeur de tension de référence sont comparées dans un comparateur et que, sur la base de ces résultats de comparaison, la durée du flanc de la tension de sortie délivrant la charge est réglée.

26. Procédé selon l'une des revendications 1 à 25, **caractérisé en ce que** les différentes étapes opératoires pour la production d'un cycle de régulation sont répétées.

27. Utilisation d'un dispositif selon l'une des revendications 1 à 13 pour le réglage d'un ou de plusieurs étages d'attaque, notamment d'un ou de plusieurs étages d'attaque de blocs, de circuits intégrés.

28. Utilisation d'un circuit d'attaque selon l'une des revendications 14 à 19, en tant qu'étage d'attaque, notamment en tant qu'étage d'attaque de bloc de circuits intégrés.

29. Utilisation d'un procédé selon l'une des revendications 20 à 26, pour le réglage d'un ou de plusieurs étages d'attaque, notamment d'un ou de plusieurs étages d'attaque de bloc, de circuits intégrés.

FIG 1

FIG 2

EP 1 264 401 B1

# FIG 3

Treibereingang

alle aktivieren

Treiberstärkewähler

51

52

52

52

52

52

92

91

90

91

91

91

93

Treiberausgang

91

91